# EUROPEAN PATENT APPLICATION

(11) **EP 4 439 914 A1**
(43) Date of publication of application: **02.10.2024**
(21) Application number: 23164263.8
(22) Date of filing: 27.03.2023
(51) Int. Cl.: H02J 7/00

(54) **A METHOD FOR CHARGING A BATTERY IN AN ELECTRIC MARINE VESSEL**

(71) Applicant: Volvo Penta Corporation, 405 08 Göteborg (SE)
(72) Inventor: LANNETOFT, Simon, 461 94 Trollhättan (SE)
(74) Representative: Zacco Sweden AB

(57) **Abstract**

A computer system (222, 322, 422, 500) comprising a processor device (502) configured to: identify a charging start of the battery (202, 302, 402) provided in an electric marine vessel (200, 300, 400), actuate a switch (220, 320, 420) on a protective earth (PE) cable (210, 310, 410) from a disconnected state to a connected state, wherein the PE cable (210, 310, 410) is provided between a PE shore connection point (214, 314, 414) on shore (208, 308, 408) and a PE hull connection point (212, 312, 412) on the vessel (200, 300, 400), initiate charging of the battery (202, 302, 402) via a charging cable (204, 304, 404) connecting the battery (202, 302, 402) on the vessel (200, 300, 400) to a power supply connection point (206, 306, 406) on the shore (208, 308, 408), identify a charging end of the battery (202, 302, 402), and actuate the switch (220, 320, 420) on the PE cable (210, 310, 410) from the connected state to the disconnected state.

## Description

### TECHNICAL FIELD

The disclosure relates generally to marine vessels. In particular aspects, the disclosure relates to a method for charging a battery in an electric marine vessel. Although the disclosure may be described with respect to a particular vessel, the disclosure is not restricted to any particular vessel.

### BACKGROUND

Today, it is common practice to provide shore power for vessels at shore facilities such as marinas. The power sources commonly comprise either a DC system or a 3-/4-wire AC system for various electrical devices onboard the vessel. The electrical devices can include one or more battery chargers, depending on the number and type of batteries, bilge pumps, air-condition units, lights and other auxiliary devices requiring electrical power.

An unwanted effect of charging or powering electrical devices on the vessel with shore power is that parts of the vessel may be subject to corrosion. More particularly, so-called galvanic corrosion may arise when a metal hull or other metallic components and a dissimilar metal, for instance the propellers, are both placed in the same aqueous solution. To avoid or at least reduce the effects of such corrosion, different counter-measures can be taken. For instance, to protect the hull, conductive fittings, paint, and other conductors in and on the vessel can be provided. Other examples of corrosion protection comprise impressed current corrosion protection (ICCP) systems and/or passive sacrificial anodes.

The corrosion is related to the occurrence of stray currents in AC (alternating current) and DC (direct current) shore power or vessel systems, and these stray currents can have different causes. For instance, the AC power source at the marina may not be properly wired and may have power, neutral, and safety ground lines interchanged (commonly called reversed polarity). Alternatively, the AC system onboard the vessel may not be properly wired, or has AC leakage to the vessel ground. These problems can cause leakage or fault AC currents and cause serious harm or failure to underwater parts and electrical devices onboard the vessel.

The DC systems provided to overcome the galvanic action, also referred to as galvanic corroision, provided on the vessel are frequently interconnected with the safety ground. Leakage currents through this path can result in accelerated corrosion. AC voltage on the safety ground represents a serious electrolysis and safety problem for all vessels and marina apparatus.

These stray currents can cause all underwater corrosion protective active elements (typically zinc's) and the more noble underwater metallic parts (e.g. bronze propellers) of the vessel with a DC ground connected to the AC safety ground wiring to be electrically connected. The result is a very large area electrolytic corrosion network, which may rapidly deplete the more active elements on the vessel. This can be made worse by the combined effect of galvanic corrosion if multiple vessels are connected to the same shore facility.

Another form of damage is electrolytic corrosion caused by introducing shore AC electrical power commonly connected into the DC ground systems of vessels. This corrosion arises due to improper wiring, leakage, and AC return line voltage drop that is inducing low levels of AC voltage into the common AC shore power safety ground. This can result in depletion of both the active elements, and the more noble underwater elements of a vessel. This type of damage attacks all through-hull fittings, corroding and eventually destroying them, so that the vessel can be subjected to flooding due to failure of the through-hull fittings.

A further failure mechanism is electrical damage that develops as a result of stray current unbalance in shore electric power delivered to the vessel. This happens when current is being supplied to the vessel, but not returning through the intended return line. The unbalanced current can be leaking off through the water into the marina, or through the safety ground. This type of failure in an otherwise properly wired vessel may be caused by movement of electrical contacts touching each other in an electrical distribution panel, or by ingress of seawater into a circuit that is intended to be insulated, but which circuit instead leaks off to ground through the wet area. Some electrical systems, like refrigerators, heaters, air-conditioners, or timer run devices may have faults that do not activate until switched on unexpectedly, long after the operators have departed the vessel.

As described above, corrosion caused by stray currents is a general problem for marine vessels. Even though different measures for reducing the effects exist, there is a need for an improved method for controlling stray currents in a marine electrical supply system.

### SUMMARY

According to a first aspect of the disclosure, a computer system comprising a processor device is disclosed. The processor device may be configured to:
identify a charging start of the battery provided in an electric marine vessel,
actuate a switch on a protective earth (PE) cable from a disconnected state to a connected state, wherein the PE cable is provided between a PE shore connection point on shore and a PE hull connection point on the vessel,
initiate charging of the battery via a charging cable connecting the battery on the vessel to a power supply connection point on the shore,
identify a charging end of the battery, and
actuate the switch on the PE cable from the connected state to the disconnected state.

The first aspect of the disclosure may seek to reduce the occurrence of stray currents by having the PE shore connection point only connected to the PE hull connection point during charging.

During charging, electrical energy is transferred via the charging cable from the power supply connection point to the battery of the vessel, that is, the charging cable as well as parts of the power supply connection point and the battery involved in the charging are energized during the charging. Put differently, a voltage is applied. When no charging occurs, the charging cable and the parts referred to above are not energized in the same manner and no voltage is applied.

The identification of the charging start can be obtained in different ways. It can be that a connection between the power supply connection point and the battery is detected by using sensors, e.g. engagements sensors, such as magnetic sensors, and that data indicative of the connection is transmitted from the power supply connection point and/or the vessel is transmitted to the computer system. Still an option is to identify the charging start by measuring a current in the charging cable, that is, the initiation of the charging is performed before the identification of the charging start. The two can also be combined, thereby making it possible to identify the charging start even in the case the transmission of the data indicative of the connection fails.

According to a second aspect it is disclosed a computer-implemented method for charging a battery provided in an electric marine vessel via a charging cable arranged to connect the battery in the vessel to a power supply connection point on shore. A protective earth (PE) cable may be provided between a PE shore connection point on the shore and a PE hull connection point on the vessel. A switch may be provided on the PE cable, thereby providing for that the PE cable may be in a connected state or in a disconnected state. The method may comprise
identifying a charging start of the battery,
actuating the switch on the PE cable from the disconnected state to the connected state, initiating charging of the battery via the charging cable,
identifying a charging end of the battery, and
actuating the switch on the PE cable from the connected state to the disconnected state.
A technical benefit may include that the stray currents occurring between the hull of the vessel and the shore can be reduced, thereby resulting in less corrosion.

In some examples, the charging cable and the PE cable outside the vessel may be integrated into one and the same device. A technical benefit may include that the risk of having the charging cable but not the PE cable connected can be reduced.

In some examples, the switch may be an electromechanical switch or a transistor.

In some examples, the switch may be provided on the vessel. An advantage with having the switch provided on the vessel is that a reduction in corrosion can be achieved for a larger variety of chargers.

In some examples, identifying the charging start of the battery may be performed by receiving charging start data from a charger providing the power supply connection point. An advantage of identifying the charging start in this way is that existing data communications interfaces can be used instead of having sensor devices provided for this purpose. Further, by combining sensor devices for identifying the charging start with having the charging start data a more resilient system can be achieved.

In some examples, the method may further comprise receiving salt content data in response to position data of the charger on the shore or the vessel, wherein the salt content data is an estimate of a water salt content for a position indicated by the position data, wherein actuating the switch on the PE cable from the connected state to the disconnected state may be performed in case the salt content data is above a threshold. An advantage with this approach is that a severity of the corrosion caused by the stray currents can be estimated based on the estimated salt content for the position of the charger and/or the vessel. Based on the estimated severity of corrosion, the switch can be set in the connected state in case this severity is deemed below the threshold, or otherwise set in the disconnected state. Put differently, if the benefit of having the PE shore connection point and the PE hull connection point disconnected is deemed low, which e.g. may be the case if the vessel is placed in a lake with freshwater (low salt content), the two points may stay connected.

In some examples, the method may further comprise estimating salt content by measuring current by using a current meter placed on the PE cable, wherein actuating the switch on the PE cable from the connected state to the disconnected state is performed in case the salt content is above a threshold. As above, an advantage with having the estimate of the salt content in the water in which the vessel is placed, the severity of the corrosion can be estimated. As an effect, since high salt content imply high conductivity, and in turn more severe corrosion, the switch may be actuated from the connected state to the disconnected state in case the salt content is above the threshold.

In some examples, the method may further comprise detecting isolation deviations between battery positive and negative pole to the PE cable in the vessel or the PE hull when the PE switch is in the disconnected state by using an on-vessel Isolation Monitoring Device (IMD) connected to the charging cable and a PE hull side of the switch. An advantage with this approach is that a possible failure resulting in a resistance drop over the battery positive and the negative pole will be detected, thereby increasing safety.

In some examples, in case charging of the battery is performed by using alternating current (AC) charging, the method may further comprise detecting leakage currents using a residual-current device (RCD) on the charging cable. An advantage with this is that failure detection can be improved, in turn resulting in increased safety.

According to a third aspect, it is provided an electric marine vessel comprising a computer system with a processor device to perform the method of the second aspect. The features and advantages discussed above with respect to the second aspect also apply to this aspect.

In some examples, the computer system may further comprise a communications interface configured to receive charging start data via a data communication network.

In some examples, the computer system may further comprises the communications interface configured to receive salt content data via the data communication network.

In some examples, the vessel further comprises a current meter placed on the PE cable such that the salt content can be estimated based on the current measured.

According to a fourth aspect, it is provided a computer program product comprising program code for performing, when executed by the processor device, the method of the second aspect. The features and advantages discussed above with respect to the second aspect also apply to this aspect.

According to a fifth aspect, it is provided a control system comprising one or more control units configured to perform the method of the second aspect. The features and advantages discussed above with respect to the second aspect also apply to this aspect.

According to a sixth aspect, it is provided a non-transitory computer-readable storage medium comprising instructions, which when executed by the processor device, cause the processor device to perform the method of the second aspect. The features and advantages discussed above with respect to the second aspect also apply to this aspect.

The above aspects, accompanying claims, and/or examples disclosed herein above and later below may be suitably combined with each other as would be apparent to anyone of ordinary skill in the art.

Additional features and advantages are disclosed in the following description, claims, and drawings, and in part will be readily apparent therefrom to those skilled in the art or recognized by practicing the disclosure as described herein. There are also disclosed herein control units, computer readable media, and computer program products associated with the above discussed technical benefits.

### BRIEF DESCRIPTION OF THE DRAWINGS

With reference to the appended drawings, below follows a more detailed description of aspects of the disclosure cited as examples.
**FIG. 1** illustrates an example of a vessel connected to a charger on shore according to the common approach of today.
**FIG. 2** illustrates an example of a vessel, according to the approach suggested herein, connected to a DC charger on the shore.
**FIG. 3** illustrates another example of the vessel, according to the approach suggested herein, connected to an AC charger on the shore.
**FIG. 4** illustrates another example of the vessel, according to the approach suggested herein, connected to a charger on shore and also connected to a data communications network.
**FIG. 5** illustrates by way of example a computer system, provided on the vessel, in further detail.
**FIG. 6** is a flowchart illustrating a method for charging the battery on the vessel according to a first example.
**FIG. 7** is a flowchart illustrating a method for charging the battery on the vessel according to a second example.

### DETAILED DESCRIPTION

Aspects set forth below represent the necessary information to enable those skilled in the art to practice the disclosure.

The problem of corrosion related to stray currents caused by charging batteries or powering electrical appliances by an on-shore charger becomes more severe for marine vessels propelled by electric motors powered by batteries. Batteries used for powering electric motors for propelling the vessel are, compared to batteries used for powering electric appliances on the vessel, generally of larger size. In other words, the batteries for powering the electric motors generally have a larger capacity compared to the batteries used for powering the electric appliances. Due to the generally higher capacity of the batteries, there is an increased interest in faster charging, that is, increased effect. This in turn provides for that the counter-measures to mitigate the effects of the power transmission from the charger to the battery or batteries on the vessel may not be sufficient. In addition, the larger batteries may also result in longer charging times, which also may increase the risk of corrosion.

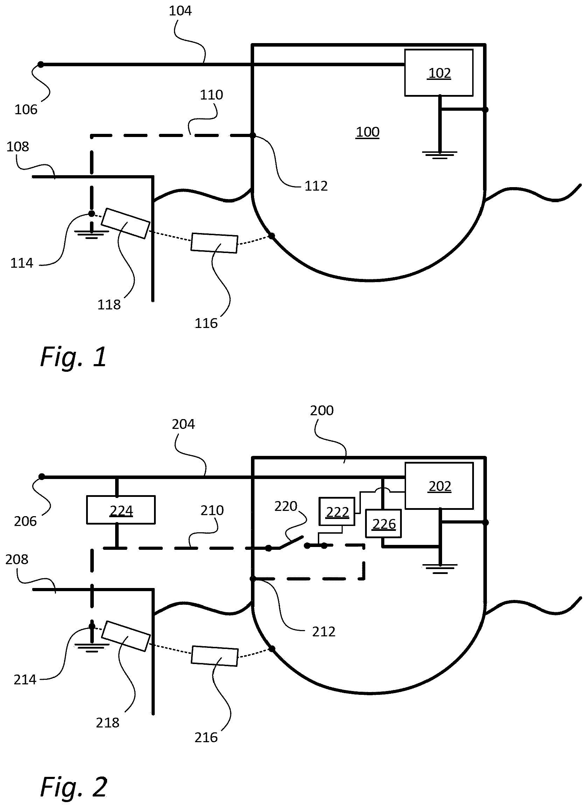

**FIG. 1** illustrates generally an electric marine vessel 100 provided with a battery 102 according to prior art. As illustrated, the battery 102 can be charged by having this connected, via a charging cable 104, to a power supply connection point 106. For safety reasons primarily, a protective earth (PE) cable 110 may connect a PE hull connection point 112 of the vessel 100 to a PE shore connection point 114 provided on shore 108. As illustrated, due to that water, particularly sea water, may function as a conductor and also that ground, that is, the shore 108, may function as a conductor, stray currents may occur from the hull of the vessel 100 via the water, having a resistance water 116, and the ground, having a resistance ground 118, to the PE shore connection point 114. As described, these stray currents may result in corrosion on the vessel 100.

**FIG. 2** illustrates generally an electric marine vessel 200 arranged to mitigate the effects of the corrosion by way of example. In line with **FIG. 1****,** the vessel 200 may be provided with a battery 202. A charging cable 204 can be provided such that power transmission from a power supply connection point 206 to the battery 202 is enabled. A PE cable 210 may connect a PE hull connection point 212 on the vessel 200 to a PE shore connection point 214 on the shore 208. As illustrated, stray currents may occur between the PE shore connection point 214 and the hull of the vessel 200 via the water, having a resistance water 216, and the ground, having a resistance ground 218.

Unlike the vessel 100 illustrated in **FIG. 1****,** the vessel 200 illustrated in **FIG. 2** can be equipped with a switch 220 on the PE cable 210. The switch 220 may be an electromechanical switch, but it may also be a transistor or any other device capable of breaking the connection between the PE hull connection point 212 and the PE shore connection point 214. The switch 220 may be controlled by a computer system 222. As illustrated, the computer system 222 may be placed on the vessel, but the computer system 222 can also be placed remotely such that the switch 220 is controlled remotely. In short, the computer system 222 can be arranged such that the switch 220 is set in a connected state during power transmission from the power supply connection point 206 to the battery 202, and in a disconnected state otherwise. Put differently, in case the charger providing the power supply connection point 206 is applying a voltage to the vessel 200, the switch 220 may be in the connected state, otherwise, in case there is no voltage applied, the switch 220 may be in the disconnected state.

In case the charger is a DC charger, as illustrated in **FIG. 2****,** an on-shore Isolation Monitoring Device (IMD) 224 may be provided between the PE cable 210 and the charging cable 204. In addition to the on-shore IMD 224, or as an alternative to this, an on-vessel IMD 226 may be provided. An advantage of using the switch 220, and having this in the connected state during power transmission and otherwise the disconnected state, in combination with the on-vessel IMD 226 is that even though that the switch 220 is in the disconnected state, and hence there is no connection between the PE shore connection point 214 and the PE hull connection point 212, the on-vessel IMD 226 can provide for that the safe environment can be maintained. Using the switch 220 can reduce the effects of corrosion due to that the stray currents can be reduced.

Even though not illustrated, the charging cable 204 and the PE cable 210 may outside the vessel be integrated into one and the same device. By way of example, by having this to integrated in this way, a user may, when connecting the vessel to the charger on the shore, provide for that the charging cable 204 is connected to the power supply connection point 206 and the PE cable 210 is connected to the PE shore connection point 214.

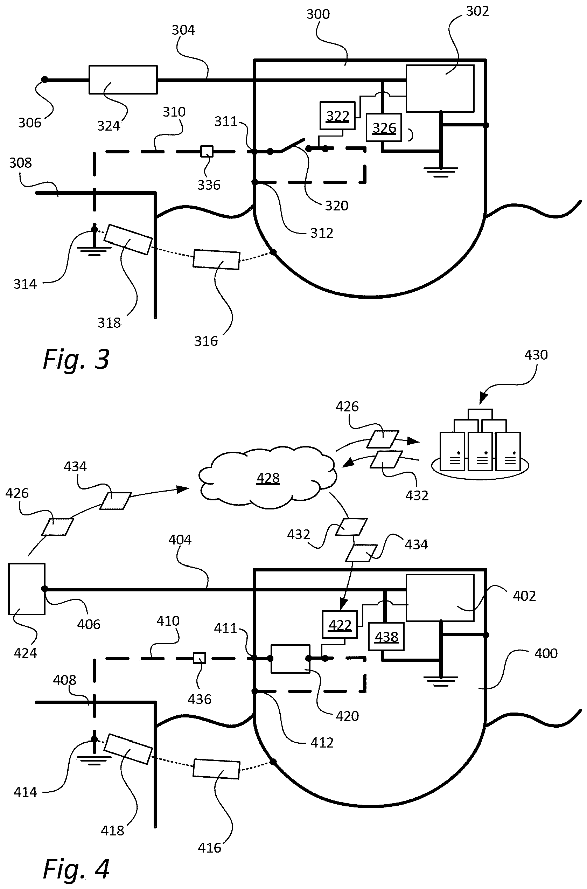

**FIG. 3** illustrates another example of an electric marine vessel 300. In line with the vessel 200 illustrated in **FIG. 2****,** the vessel 300 of **FIG. 3** can comprise a battery 302 that can be connected via a charging cable 304 to a power supply connection point 306, which may be provided by a charger. Further, a PE cable 310 may connect the hull of the vessel, more particularly a PE hull connection point 312 to a PE shore connection point 314 on shore 308. Stray currents may occur between the hull of the vessel 300 and the PE shore connection point 314 via the water, having resistance water 316, and ground, having resistance ground 318. To reduce the effects of these stray currents, a switch 320 controlled by a computer system 322 may be provided. As outlined above, by having the switch 320 in the connected state during power transmission between the charger, providing the power supply connection point 306, and the battery 302, and otherwise in the disconnected state, the stray currents can reduced.

In case the charger is an AC charger, as illustrated in **FIG. 3****,** a residual current device (RCD) 324 can be applied on the charging cable 304 to detect leakage currents. In case such leakage currents are detected, the RCD may break the connection between the power supply connection point 306 and the vessel 300 such that safety can be maintained and the risk of damaging electric devices on the vessel 300 can be mitigated.

In line with the example illustrated in **FIG. 2****,** an on-vessel IMD 326 may be provided to make sure that a safe environment is maintained.

Since a salt content of the water correlates to a conductivity of the water, a current meter 336 may be provided on the PE cable 310 such that the salt content can be estimated by measuring the current. In case it is estimated that the salt content is above a threshold, the computer system 322 may be configured to actuate the switch from the connected state to the disconnected state, thereby reducing the stray currents causing corrosion.

**FIG. 4** illustrates yet another example of an electric marine vessel 400 provided with a battery 402. In line with the examples illustrated in **FIG. 2** and **FIG. 3****,** a charging cable 404 can be provided between a power supply connection point 406 and the battery 402. A PE cable 410 can be provided between a PE hull connection point 412 and the PE shore connection point 414 on shore 408. Stray currents may occur between the hull of the vessel 400 and the PE shore connection point 414 via the water, having resistance water 416 and ground, having resistance ground 418. A switch 420, which may be an electromechanical switch as illustrated in **FIG. 2** and **FIG. 3** by way of example, a transistor or any other device for breaking the connection, can be provided on the PE cable 410. As described above with reference to **FIG. 2** and **FIG. 3****,** the switch 420 can be controlled by a computer system 422.

In addition to what is illustrated in **FIG. 2** and **FIG. 3****,** a charger 424 may provide the power supply connection point 406. The charger 424 may be equipped with a positioning device, such as a GPS device, for determining position data 426, that is, a geographical position of the charger 424. The position data 426 may be transferred via a data communication network 428 to a server 430, or other equipment for processing and holding data. Since salt content of the water is different for different geographical positions, by using a database, a table or the like, the server 430 may, based on the position data 426, determine salt content data 432. The salt content data 434 may be provided to the computer system 422 of the vessel 400 via the data communication network 428. The computer system 422 may be provided with a communications interface for enabling communication via the data communication network 428.

The conductivity of water correlates to the salt content of the water. Thus, by way of example, the severity of the corrosion on the vessel 400 caused by the stray currents is generally higher in case the vessel is placed in sea water compared to if the vessel 400 is placed in lake water, that is, in water having a lower salt content than the sea water. Therefore, by having the salt content data 432, in case the salt content is above a threshold, which may be a pre-set threshold, the computer system 422 may disconnect the switch 420 after charging is completed, while, on the other hand, the salt content is below the threshold the switch 420 may be kept connected. Put differently, in case the salt content data 432 suggests that severe corrosion would occur in case the switch 420 may be kept in the connected state, the switch 420 may be actuated such that the switch 420 is set in the disconnected state. On the other hand, in case the salt content data 432 suggests that there will be no severe corrosion, the switch 420 may be set to remain in the connected state. How to define the severity of the corrosion may be depend on a number of factors, and it can be reflected in how the threshold is set.

Even though illustrated in **FIG. 4** that the salt content data 434 is transmitted to the computer system 422 of the vessel 400, it is equally possible to compare the salt content data 434 with the threshold in the server 430 and send a result of the comparison, e.g. an instruction to disconnect after charging is completed or an instruction to stay connected after charging is completed. Further, even though it is illustrated that the charger 424 is equipped with the positioning device, the vessel 400 may also, or instead, be equipped with the positioning device such that the position data 426 can be transmitted from the vessel 400 to the server 430. In case the vessel 400 is equipped with the positioning device, the vessel 400 may also be provided with the database or list, linking the position data 426 to salt content data 434, such that the salt content data 434 can be determined within the vessel 400.

As illustrated, the charger 424 may transmit charging start data 434 via the data communications network 428 to the vessel 400, more particularly the computer system 422 of the vessel 400. In this way, as an alternative to measuring on the charging cable 404 or in combination with such measurement, a charging start may be identified. Even though not illustrated, in addition, charging end data, also referred to as charging completion data, may be provided by the charger 424 to the computer system 422 as an alternative or as a complement to measurements on e.g. the charging cable 404 such that a charging end can be determined.

As a complement or alternative to estimating the salt content by using the position data 426 as described above, possibly in combination with weather data, it is also possible to estimate the salt content by using a current meter 436 in line with the description above related to **FIG. 3****.** In line with **FIG. 3****,** the current meter 436 may be provided on the PE cable 410.

As also illustrated in **FIG. 2** and **FIG. 3****,** an on-vessel IMD 438 may be provided to maintain a safe environment.

Even though three examples are described above with reference to **FIG. 2** to **FIG.** 4, it is to be noted that the three examples should not be viewed in isolation. **FIG. 2** is, as described above, related to an example in which the charger providing the power supply connection point is a DC charger. **FIG. 3** is, as described above, an example in which the charger is an AC charger. **FIG. 4** is related to an example in which the charger and the vessel is communicatively connected via the data communication network. Aspects and advantages described in any of these examples can be applied broadly unless explicitly stated otherwise.

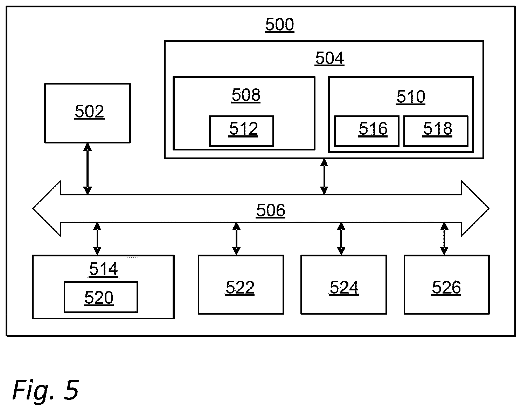

**FIG. 5** is a schematic diagram of a computer system 500 for implementing examples disclosed herein. The computer system 500 is adapted to execute instructions from a computer-readable medium to perform these and/or any of the functions or processing described herein. The computer system 500 may be connected (e.g., networked) to other machines in a LAN, an intranet, an extranet, or the Internet. While only a single device is illustrated, the computer system 500 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 500 may comprise at least one computing device or electronic device capable of including firmware, hardware, and/or executing software instructions to implement the functionality described herein. The computer system 500 may include a processor device 502 (may also be referred to as a control unit), a memory 504, and a system bus 506. The computer system 500 may include at least one computing device having the processor device 502. The system bus 506 provides an interface for system components including, but not limited to, the memory 504 and the processor device 502. The processor device 502 may include any number of hardware components for conducting data or signal processing or for executing computer code stored in memory 504. The processor device 502 (e.g., control unit) may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processor device may further include computer executable code that controls operation of the programmable device.

The system bus 506 may be any of several types of bus structures that may further interconnect to a memory bus (with or without a memory controller), a peripheral bus, and/or a local bus using any of a variety of bus architectures. The memory 504 may be one or more devices for storing data and/or computer code for completing or facilitating methods described herein. The memory 504 may include database components, object code components, script components, or other types of information structure for supporting the various activities herein. Any distributed or local memory device may be utilized with the systems and methods of this description. The memory 504 may be communicably connected to the processor device 502 (e.g., via a circuit or any other wired, wireless, or network connection) and may include computer code for executing one or more processes described herein. The memory 504 may include non-volatile memory 508 (e.g., read-only memory (ROM), erasable programmable read-only memory (EPROM), electrically erasable programmable read-only memory (EEPROM), etc.), and volatile memory 510 (e.g., random-access memory (RAM)), or any other medium which can be used to carry or store desired program code in the form of machine-executable instructions or data structures and which can be accessed by a computer or other machine with a processor device 502. A basic input/output system (BIOS) 512 may be stored in the non-volatile memory 508 and can include the basic routines that help to transfer information between elements within the computer system 500.

The computer system 500 may further include or be coupled to a non-transitory computer-readable storage medium such as the storage device 514, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 514 and other drives associated with computer-readable media and computer-usable media may provide non-volatile storage of data, data structures, computer-executable instructions, and the like.

A number of modules can be implemented as software and/or hard-coded in circuitry to implement the functionality described herein in whole or in part. The modules may be stored in the storage device 514 and/or in the volatile memory 510, which may include an operating system 516 and/or one or more program modules 518. All or a portion of the examples disclosed herein may be implemented as a computer program product 520 stored on a transitory or non-transitory computer-usable or computer-readable storage medium (e.g., single medium or multiple media), such as the storage device 514, which includes complex programming instructions (e.g., complex computer-readable program code) to cause the processor device 502 to carry out the steps described herein. Thus, the computer-readable program code can comprise software instructions for implementing the functionality of the examples described herein when executed by the processor device 502. The processor device 502 may serve as a controller or control system for the computer system 500 that is to implement the functionality described herein.

The computer system 500 also may include an input device interface 522 (e.g., input device interface and/or output device interface). The input device interface 522 may be configured to receive input and selections to be communicated to the computer system 500 when executing instructions, such as from a keyboard, mouse, touch-sensitive surface, etc. Such input devices may be connected to the processor device 502 through the input device interface 522 coupled to the system bus 506 but can be connected through other interfaces such as a parallel port, an Institute of Electrical and Electronic Engineers (IEEE) 1394 serial port, a Universal Serial Bus (USB) port, an IR interface, and the like. The computer system 500 may include an output device interface 524 configured to forward output, such as to a display, a video display unit (e.g., a liquid crystal display (LCD) or a cathode ray tube (CRT)). The computer system 500 may also include a communications interface 526 suitable for communicating with a network as appropriate or desired.

The operational steps described in any of the exemplary aspects herein are described to provide examples and discussion. The steps may be performed by hardware components, may be embodied in machine-executable instructions to cause a processor to perform the steps, or may be performed by a combination of hardware and software. Although a specific order of method steps may be shown or described, the order of the steps may differ. In addition, two or more steps may be performed concurrently or with partial concurrence.

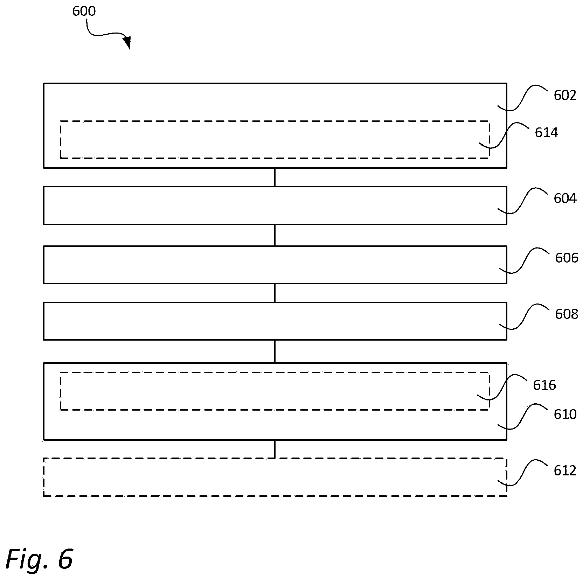

**FIG. 6** is a flow chart of a method 600 for charging the battery 202, 302, 402 according to one example. Generally, the method 600 may comprise identifying 602 the charging start of the battery 202, 302, 402, actuating 604 the switch 220, 320, 420 on the PE cable 210, 310, 410 from the disconnected state to the connected state, initiating 606 charging of the battery 202, 302, 402 via the charging cable 204, 304, 404, identifying 608 the charging end of the battery 202, 302, 402, and actuating 610 the switch 220, 320, 420 on the PE cable 210, 310, 410 from the connected state to the disconnected state.

The method 600 may further comprise detecting 612 isolation deviations between battery positive and negative pole to the PE cable in the vessel or the PE hull when the switch 220, 320, 420 is in the disconnected state by using the on-vessel IMD 226, 326, 438 connected to the charging cable 204, 304, 404 and a PE hull side of the switch 220, 320, 420.

Optionally, identifying 602 the charging start of the battery may be performed by receiving 614 the charging start data 434 from the charger 424 providing the power supply connection point 406.

Optionally, the method 600 may further comprise estimating 616 salt content by measuring current by using a current meter 336, 436 placed on the PE cable 310, 410, wherein actuating 610 the switch from the connected state to the disconnected state is performed in case the salt content is above a threshold.

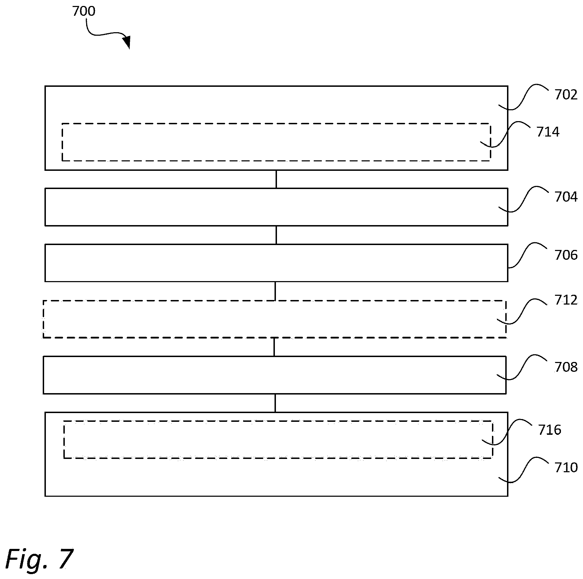

**FIG. 7** is a flow chart of a method 700 for charging the battery 202, 302, 402 according to another example. Generally, the method 700 may comprise identifying 702 the charging start of the battery 202, 302, 402, actuating 704 the switch 220, 320, 420 on the PE cable 210, 310, 410 from the disconnected state to the connected state, initiating 706 charging of the battery 202, 302, 402 via the charging cable 204, 304, 404, identifying 708 the charging end of the battery 202, 302, 402, and actuating 710 the switch 220, 320, 420 on the PE cable 210, 310, 410 from the connected state to the disconnected state.

In case charging 706 of the battery 302, 402 is performed by using AC charging, the method 700 may further comprise detecting 712 leakage currents using a RCD on the charging cable 304.

Optionally, identifying 702 the charging start of the battery may be performed by receiving 714 the charging start data 434 from the charger 424 providing the power supply connection point 406.As an alternative or a complement, the charging start data 434 may be received from a control device on the vessel.

Optionally, the method 700 may further comprise estimating 716 salt content by measuring current by using a current meter 336, 436 placed on the PE cable 310, 410, wherein actuating 710 the switch from the connected state to the disconnected state is performed in case the salt content is above a threshold.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the inventive concepts being set forth in the following claims.

## Claims

1. A computer system (222, 322, 422, 500) comprising a processor device (502) configured to:
identify a charging start of the battery (202, 302, 402) provided in an electric marine vessel (200, 300, 400),
actuate a switch (220, 320, 420) on a protective earth (PE) cable (210, 310, 410) from a disconnected state to a connected state, wherein the PE cable (210, 310, 410) is provided between a PE shore connection point (214, 314, 414) on shore (208, 308, 408) and a PE hull connection point (212, 312, 412) on the vessel (200, 300, 400),
initiate charging of the battery (202, 302, 402) via a charging cable (204, 304, 404) connecting the battery (202, 302, 402) on the vessel (200, 300, 400) to a power supply connection point (206, 306, 406) on the shore (208, 308, 408),
identify a charging end of the battery (202, 302, 402), and
actuate the switch (220, 320, 420) on the PE cable (210, 310, 410) from the connected state to the disconnected state.

2. A computer-implemented method (600, 700) for charging a battery (202, 302, 402) provided in an electric marine vessel (200, 300, 400) via a charging cable (204, 304, 404) arranged to connect the battery (202, 302, 402) on the vessel (200, 300, 400) to a power supply connection point (206, 306, 406) on shore (208, 308, 408), wherein a protective earth (PE) cable (210, 310, 410) is provided between a PE shore connection point (214, 314, 414) on the shore (208, 308, 408) and a PE hull connection point (212, 312, 412) on the vessel (200, 300, 400), wherein a switch (220 ,320, 420) is provided on the PE cable (210, 310, 410), thereby providing for that the PE cable (210, 310, 410) is in a connected state or in a disconnected state, said method (600, 700) comprising
identifying (602, 702) a charging start of the battery (202, 302, 402),
actuating (604, 704) the switch (220, 320, 420) on the PE cable (210, 310, 410) from the disconnected state to the connected state,
initiating (606, 706) charging of the battery (202, 302, 402) via the charging cable (204, 304, 404),
identifying (608, 708) a charging end of the battery (202, 302, 402), and
actuating (610, 710) the switch (220, 320, 420) on the PE cable (210, 310, 410) from the connected state to the disconnected state.

3. The method (600, 700) according to claim 2, wherein the charging cable (204, 304, 404) and the PE cable (210, 310, 410) outside the vessel are integrated into one and the same device.

4. The method (600, 700) according to claim 2 or 3, wherein the switch (220, 320, 420) is an electromechanical switch or a transistor.

5. The method (600, 700) according to any one of the claims 2 to 4, wherein the switch (220, 320, 420) is provided on the vessel (200, 300, 400).

6. The method (600, 700) according to any one of the claims 2 to 5, wherein identifying (602, 702) the charging start of the battery is performed by receiving (614, 714) charging start data (434) from a charger (424) providing the power supply connection point (406).

7. The method (600, 700) according any one of the claims 2 to 6, further comprising estimating (616, 716) salt content by measuring current by using a current meter (336, 436) placed on the PE cable (310, 410), wherein actuating (610, 710) the switch (320, 420) on the PE cable (310, 410) from the connected state to the disconnected state is performed in case the salt content is above a threshold.

8. The method (600) according to any one of the claims 2 to 7, further comprising detecting (612) isolation deviations between battery positive and negative pole to the PE cable in the vessel or the PE hull when the switch (220, 320, 420) is in the disconnected state by using an on-vessel Isolation Monitoring Device (IMD) (226, 326, 438) connected to the charging cable (204, 304, 404) and a PE hull side of the switch (220, 320, 420).

9. The method (700) according to any one of the claims 2 to 8, in case charging (706) of the battery (302, 402) is performed by using alternating current (AC) charging, further comprising
detecting (712) leakage currents using a residual-current device (RCD) (324) on the charging cable (304).

10. An electric marine vessel (200, 300, 400) comprising a computer system (500) with a processor device (502) to perform the method of any of claims 2-9.

11. The vessel according to claim 10, wherein the computer system (500, 222, 322, 422) further comprises a communications interface (526) configured to receive charging start data (434) via a data communication network (428).

12. The vessel according to claim 10 or 11, further comprising a current meter (336, 436) placed on the PE cable (310, 410) such that the salt content can be estimated based on the current measured.

13. A computer program product comprising program code for performing, when executed by the processor device, the method of any of claims 2-9.

14. A control system comprising one or more control units configured to perform the method of any of claims 2-9.

15. A non-transitory computer-readable storage medium comprising instructions, which when executed by the processor device (502), cause the processor device to perform the method of any of claims 2-9.
